**Europäisches Patentamt**

**European Patent Office**

**Office européen des brevets**

(11) Numéro de publication: **0 006 054**
**A1**

## (12) DEMANDE DE BREVET EUROPEEN

(21) Numéro de dépôt: **79400330.1**

(22) Date de dépôt: **23.05.79**

(51) Int. Cl.²: **H 03 H 9/26**
**H 04 N 9/32**

(30) Priorité: **06.06.78 FR 7816868**

(43) Date de publication de la demande:
**12.12.79 Bulletin 79/25**

(84) Etats Contractants Désignés:
**AT BE CH DE GB IT NL SE**

(71) Demandeur: **"THOMSON-CSF"**
**173, boulevard Haussmann**
**F-75360 Paris Cedex 08(FR)**

(72) Inventeur: **Coussot, Gérard**
**"THOMSON-CSF" - SCPI 173, bld Haussmann**
**F-75360 Paris Cedex 08(FR)**

(72) Inventeur: **Menager, Olivier**
**"THOMSON-CSF" - SCPI 173, bld Haussmann**
**F-75360 Paris Cedex 08(FR)**

(72) Inventeur: **Van Den Driessche, Michel**
**"THOMSON-CSF" - SCPI 173, bld Haussmann**
**F-75360 Paris Cedex 08(FR)**

(74) Mandataire: **Desperrer, Jean-Louis et al,**
**"Thomson-CSF" - SCPI 173, Bld Haussmann**
**F-75 360 Paris Cedex 08(FR)**

(54) Filtre à ondes élastiques de surface et étage de fréquence intermédiaire d'un récepteur de télévision comprenant un tel filtre.

(57) L'invention concerne les filtres à ondes élastiques de surface réalisés sur une plaquette piézo-électrique.

Le filtre selon l'invention comprend, à la surface (S) de la plaquette (1), un transducteur d'émission (2-3), un coupleur d'ondes de surface (4) et des moyens récepteurs des ondes rayonnées par le coupleur comprenant deux transducteurs (51-51 et 61-62) ayant une première borne commune (M) servant de référence de phase, les tensions des deuxièmes bornes ($B_1$ et $B_2$) de chaque transducteur par rapport à la borne commune étant en opposition de phase dans la bande de transmission du filtre.

L'invention s'applique notamment à la réception des signaux de télévision.

EP 0 006 054 A1

./...

Fig. 2

# FILTRE A ONDES ELASTIQUES DE SURFACE ET ETAGE DE FREQUENCE INTERMEDIAIRE D'UN RECEPTEUR DE TELEVISION COMPRENANT UN TEL FILTRE.

L'invention concerne les filtres à ondes élastiques de surface réalisés sur une plaquette piézoélectrique et utilisés notamment dans le domaine de la télévision.

Il est connu, pour réaliser un filtrage d'un signal électrique de bande passante donnée, de réaliser une ligne à retard en disposant sur une plaquette piézoélectrique deux transducteurs, chacun formé de deux peignes à dents intercalées. L'un des deux transducteurs reçoit le signal électrique, ce qui provoque l'émission d'ondes élastiques de surface dans le matériau piézoélectrique. L'autre transducteur capte ces ondes et fournit une tension électrique dont l'amplitude complexe dépend de la configuration des peignes. Pour obtenir le gabarit de filtrage souhaité, la longueur des dents est choisie pour obtenir une pondération du transducteur d'émission assimilable à la transformée de Fourier de la fonction de transfert souhaitée. Il est également connu, pour éliminer les parasites provenant de la propagation d'ondes de volume en même temps que les ondes de surface, de disposer entre les transducteurs d'émission et de réception un coupleur d'ondes élastiques de surface formé de filaments conducteurs assurant un couplage maximum des ondes de surface et un couplage nul des ondes de volume.

Dans l'application au filtrage des signaux de fréquence intermédiaire transmis par le canal d'amplification vidéo, les extrémités des deux peignes constituant le transducteur de réception du filtre sont connectées à des circuits amplificateurs, généralement à entrées différentielles. La sortie du filtre étant en masse flottante, il existe des problèmes de sensibilité entraî-

2

nant des accrochages au niveau des signaux de démodulation.

L'invention consiste en un perfectionnement des filtres à ondes de surface grâce auquel ces problèmes peuvent être atténués. Le transducteur de sortie possédant deux bornes sans référence de phase est remplacé par deux transducteurs possédant un peigne commun à double rangées de dents et fournissant trois bornes de sortie, l'une servant de masse par rapport à laquelle les tensions recueillies sur les deux autres sont en opposition de phase.

L'invention sera mieux comprise au moyen de la description ci-après et des figures qui l'accompagnent parmi lesquelles :

- la figure 1 représente un filtre à ondes élastiques de surface de type connu.

- la figure 2 représente un filtre selon l'invention.

- les figures 3 et 4 sont des détails de réalisation des transducteurs de sortie.

- la figure 5 est un schéma d'une application de l'invention.

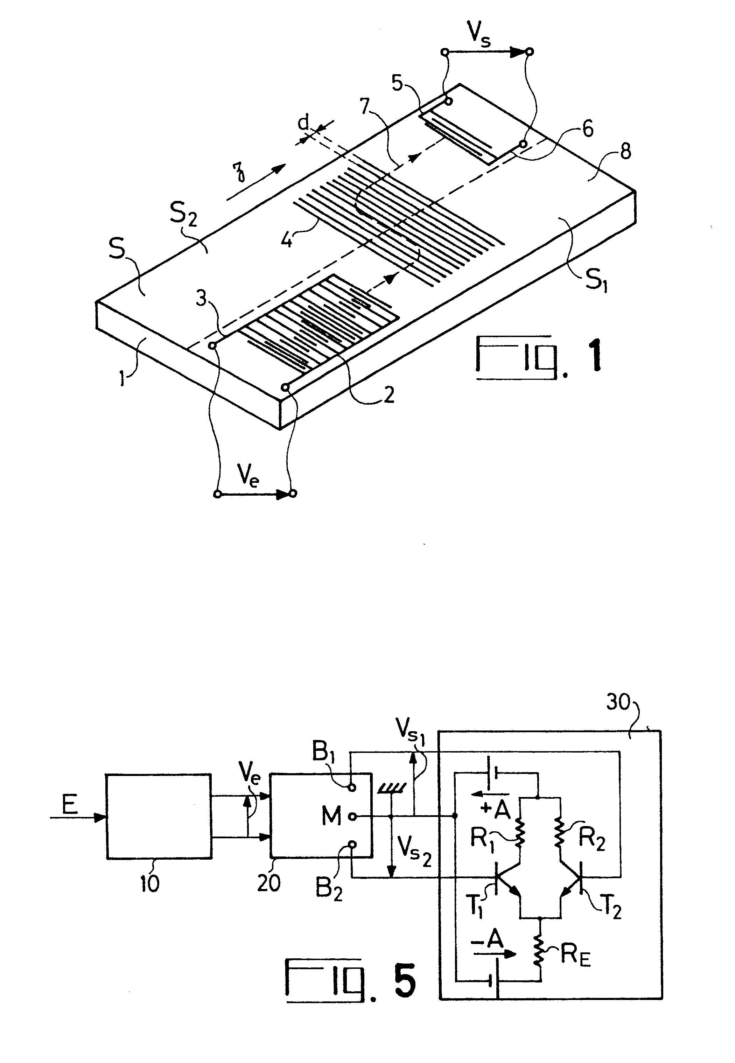

La figure 1 représente un filtre à ondes élastiques de surface de type connu. Il comprend une plaquette 1 réalisée dans un matériau piézoélectrique. Sur l'une des faces, S, de la plaquette, sont déposés des réseaux transducteurs constitués de couches minces de métal : un transducteur d'émission d'ondes élastiques de surface en forme de deux peignes interdigités 2 et 3 aux extrémités desquels on peut appliquer un signal d'excitation $V_e$ générant dans la surface S des ondes élastiques et un transducteur de réception également en forme de deux peignes interdigités 5 et 6 entre lesquels on peut recueillir un signal $V_s$ correspondant au signal $V_e$ avec un retard dépendant de la vitesse de propagation des ondes élastiques et de la longueur de propagation.

Si l'on sépare par l'esprit la surface S en deux moitiés $S_1$ et $S_2$ selon la direction de propagation z, le transducteur d'entrée est localisé dans la moitié $S_1$ et le transducteur de sortie dans la moitié $S_2$. Entre les deux transducteurs est disposé un coupleur d'ondes élastiques de surface constitué par des filaments conducteurs 4 dont le nombre et l'espacement d sont choisis en fonction de la longueur d'onde élastique de façon que les ondes de surface issues du transducteur d'entrée soient réémises en totalité par le coupleur en direction du transducteur de sortie, tandis que les ondes de volume ne voient pas leur trajet modifié par le coupleur, n'aboutissent pas au transducteur de réception et donc ne créent pas de parasites. Expérimentallement, on obtient un rendement de transmission des ondes de surface proche de 100 % avec environ 110 filaments espacés d'environ une demi-longueur d'onde élastique. On a symbolisé sur la figure le trajet 7 suivi par les ondes de surface. La partie de ce trajet parallèle aux filaments ne correspond pas strictement au trajet réel mais illuste le décrochement dans le trajet des ondes de surface entre la partie située en amont du coupleur 4 et la partie située en aval.

Pour réaliser un filtre passe-bande avec le dispositif à ondes de surface représenté sur la figure 1, il est nécessaire d'adopter une configuration particulière pour les peignes 2 et 3 du transducteur d'émission. On constate sur la figure que les dents des peignes ne sont pas d'égale longueur et que leur enveloppe a une allure en $\frac{\sin x}{x}$. On sait que la réponse impulsionnelle d'un tel transducteur est également en $\frac{\sin x}{x}$ et la réponse en fréquence, qui est la transformée de Fourier de la réponse impulsionnelle a la forme quasi rectangulaire d'un filtre passe-bande. L'écartement des dents détermine la fréquence centrale de la bande passante du filtre : il vaut $\frac{\lambda}{2}$, $\lambda$ étant la longueur d'onde des ondes élastiques propagées. Le nombre de

4

dents des peignes 2 et 3 détermine la largeur de cette bande passante. Celle-ci sera d'autant plus large que le nombre de dents sera faible. Toutefois, ce nombre doit être suffisant pour définir plusieurs lobes de la fonction $\frac{\sin x}{x}$, en vue d'obtenir une réponse en fréquence la plus rectangulaire possible. Le nombre de dents des peignes 2 et 3 est généralement de l'ordre d'une centaine, alors que le nombre de dents des peignes 5 et 6 peut être beaucoup plus faible, par exemple une dizaine. La forme particulière du transducteur d'entrée convenant au gabarit de filtrage souhaité conduit à l'émission d'ondes ayant un front d'onde fortement distordu, l'intensité n'étant pas également répartie dans toute la largeur de la zone $S_1$. Le coupleur restitue dans la zone $S_2$ des ondes ayant un front d'onde à distribution uniformément répartie.

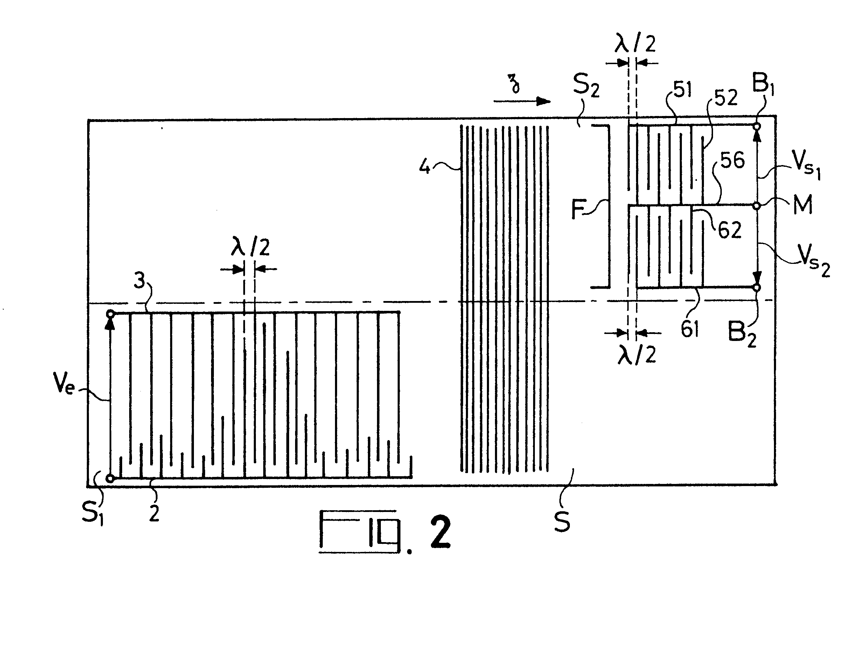

Dans certaines de ses applications, un filtre passe-bande tel que celui de la figure 1 présente un inconvénient important : la sortie ne présentant pas de référence de phase, lorsqu'on y branche un dispositif à entrée différentielle, un amplificateur différentiel, par exemple, on observe un mauvais fonctionnement de ce dispositif et des parasites gênants. Il serait préférable d'appliquer aux deux entrées différentielles du dispositif des tensions en opposition de phase et d'égale intensité mais de polarités opposées par rapport à la masse du dispositif. Or, les filtres à ondes de surface de type connu n'ont pas une structure fournissant de tels signaux. L'invention consiste à modifier le schéma du filtre de la figure 1, de façon à avoir trois bornes de sortie : une borne que l'on pourra relier à la masse du dispositif à entrées différentielles, constituant une référence de phase et deux bornes symétriques, c'est-à-dire recueillant des tensions en opposition de phase par rapport à la borne de référence. Une vue de dessus du filtre selon l'invention est représentée sur la figure 2. Certains éléments sont communs avec la figure 1 et portent les mêmes références. Le filtre selon l'invention comprend, à la surface S d'une plaquette piézoélectrique, un transducteur d'émission formé de deux peignes interdigités 2 et 3, dont la forme des dents décrit une courbe $\dfrac{\sin x}{x}$. Ce transducteur est situé dans la moitié $S_1$ de la surface S. Derrière le transducteur d'émission sont disposés des filaments conducteurs 4 s'étendant sur toute la largeur de la plaquette et constituant le coupleur d'ondes de surface dont le rôle a été décrit plus haut. Ce coupleur délivre dans la moitié $S_2$ de la surface S des ondes élastiques de surface possèdant un front d'onde rectangulaire à distribution d'intensité uniformément réparti tel que celui, F, schématisé sur la figure 1. Les moyens récepteurs de ces ondes consistent en deux transducteurs à peignes interdigités : deux peignes à simple rangée de dents, 51 et 61, et un peigne 56 à deux rangées de dents, 52 et 62, les dents des deux rangées 52 et 62 étant respectivement intercalées avec le peigne 51 pour former un premier transducteur, et avec le peigne 61 pour former le deuxième transducteur. Le peigne 56 est relié à une borne de masse M. Les peignes 51 et 61 sont respectivement reliés aux bornes $B_1$ et $B_2$. Les dents sont disposées parallèlement au front d'onde F, perpendiculairement à la direction de propagation z. La distance entre une dent d'un des peignes 51 et 61 et la dent la plus proche de la rangée de dents correspondante du peigne 56 est constante et égale à une demi-longueur d'onde. Dans le sens de propagation z, la première dent du peigne 51 est située dans le prolongement de la première dent de la rangée 62. De même, la première dent du peigne 61 est située dans le prolongement de la première dent de la rangée 52, à une demi-longueur d'onde des précédentes. Ainsi, le champ électrique $E_1$ créé dans le premier transducteur formé par les dents 51 et 52 et le champ électri-

6

que $E_2$ créé dans le deuxième transducteur formé par les dents 61 et 62 par une onde élastique incidente sont d'égale intensité et de sens opposés. En sortie, on obtient une tension $V_{S1}$ entre les bornes M et $B_1$ et une tension $V_{S2}$ entre les bornes M et $B_2$. Ces tensions sont égales et en opposition de phase dans toute la bande passante du filtre. Cet effet a pu être obtenu, d'une part grâce au coupleur qui fournit des ondes à distribution d'intensité uniformément répartie, d'autre part, grâce à l'agencement des doigts des trois peignes 51, 56, 61.

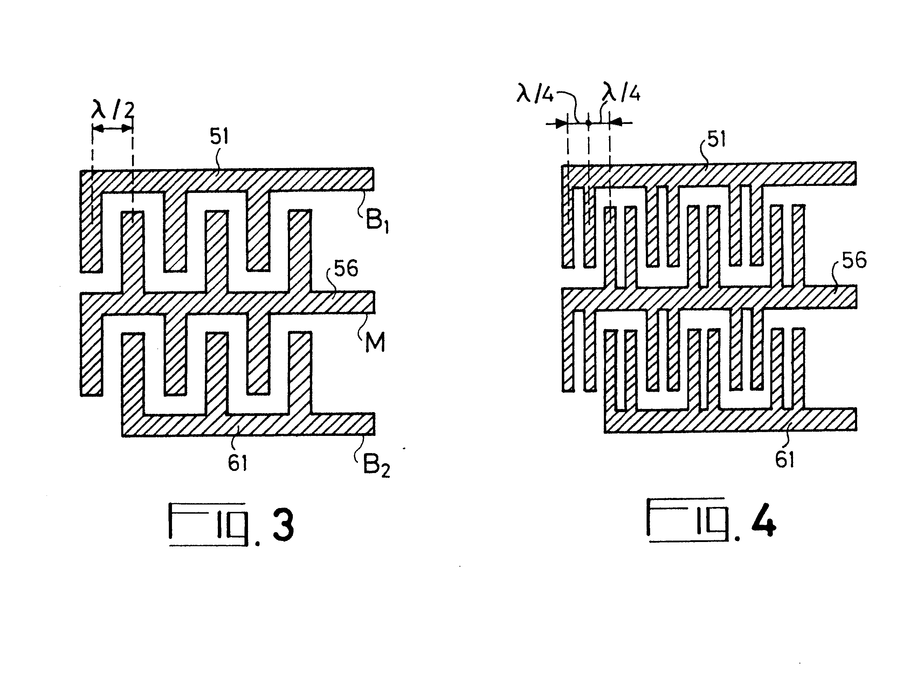

Le transducteur d'émission, le coupleur et les 2 transducteurs de sortie sont réalisables par des procédés classiques de photolithographie. La forme exacte du transistor d'émission admet diverses variantes qui font partie de l'art connu. La forme exacte des transducteurs de sortie peut également varier. Deux configurations sont représentées sur les figures 3 et 4. Sur la figure 3, on a une configuration "conventionnelle". Les doigts des peignes 51, 56, 61, sont constitués de bandes métalliques (hachurées sur la figure), la distance d'une demi-longueur d'onde entre 2 doigts consécutifs se partageant à peu près également entre la partie métallisée et l'intervalle non métallisé. Les doigts faisant partie d'un même peigne sont raccordés à une même bande métallique dont l'extrémité forme les bornes $B_1$, M, $B_2$.

Sur la figure 4, on a une configuration "à doigts divisés". Chaque doigt est constitué de 2 bandes métalliques (hachurées) séparées par un intervalle non métallisé. La distance entre 2 bandes est égale à un quart de longueur d'onde se partageant à peu près également entre la partie métallisée et la partie non métallisée. La distance entre deux doigts consécutifs de 2 peignes différents reste d'une demi-longueur d'onde pour les 2 transducteurs. Cette configuration permet d'annuler

7

les parasites provenant des ondes élastiques se réfléchissant sur les bandes métalliques. En effet, avec
la configuration de la figure 3, les ondes réfléchies
par tous les doigts se trouvent en phase et s'ajoutent.
Avec la configuration de la figure 4, elles se trouvent
en opposition de phase et se détruisent.

On obtient des résultats analogues en utilisant,
non plus le mode de propagation fondamental, mais un mode
harmonique, par exemple en espaçant deux doigts consécutifs de $\frac{3\lambda}{2}$ (utilisation de l'harmonique 3). Dans une
configuration à doigts divisés la largeur de chaque bande
métallique étant plus large : $\frac{3\lambda}{8}$ au lieu de $\frac{\lambda}{8}$ , la
réalisation est plus aisée.

Un filtre à ondes élastiques de surface selon
l'invention s'applique notamment à la réception des
signaux de télévision.

La figure 5 est un schéma d'une partie de l'étage
de fréquence intermédiaire d'un récepteur de télévision.
Cet étage reçoit un signal moyenne fréquence E. Un détecteur vidéo 10 extrait du signal E une tension Ve contenant les informations relatives à la luminance et à la
chrominance. Cette tension est appliquée à l'entrée
du filtre passe-bande 20 du type décrit plus haut, c'est-
à-dire à ondes élastiques de surface et à sorties symétriques. Ce filtre permet d'extraire la bande de fréquence du canal image. On branche à la sortie du filtre
un démodulateur précédé d'un amplificateur. Les fonctions d'amplification et de démodulation peuvent être
réalisées par un même circuit intégré 30 du type TBA
440, TBA 1440, TDA 4420, TBA 2541 ... On a représenté
sur la figure le premier étage d'un amplificateur différentiel présentant l'entrée d'un de ces circuits intégrés afin de mettre en évidence le branchement du filtre
selon l'invention avec n'importe quel dispositif à entrées
différentielles. Cet étage comprend deux transistors $T_1$
et $T_2$ dont les émetteurs sont reliés entre eux et alimen-

8

tés par une tension continue négative -A par rapport à la masse du circuit 30 par l'intermédiaire d'une résistance commune $R_E$ et dont les collecteurs sont alimentés par une tension continue positive +A par rapport à la masse et par l'intermédiaire respectivement des résistances $R_1$ et $R_2$. Les entrées du circuit 30 sont les bases des transistors $T_1$ et $T_2$. Elles sont respectivement reliées aux bornes de sortie $B_1$ et $B_2$ du filtre 20, tandis que la masse du circuit 30 est reliée à la borne M du filtre 20. Comme on l'a vu plus haut, les tensions appliquées aux deux bases sont toujours de même valeur mais de signes opposés et en opposition de phase par rapport à la masse.

9

REVENDICATIONS

1. Filtre à ondes élastiques de surface comprenant, sur l'une des faces d'une plaquette piézoélectrique partagée en deux moitiés par une ligne parallèle à la direction de propagation des ondes, un transducteur d'émission des ondes élastiques de surface situé dans l'une des moitiés de la face, des moyens récepteurs des ondes se propageant dans la deuxième moitié de la face, et un coupleur s'étendant sur les deux moitiés, intercalé entre le transducteur d'émission et les moyens de réception, la portion de ce coupleur située dans la première moitié étant irradiée par les ondes de surface émises par le transducteur d'émission et la portion du coupleur située dans la deuxième moitié rayonnant les ondes de surface en direction des moyens récepteurs, caractérisé en ce que ces moyens récepteurs comprennent deux transducteurs ayant une première borne commune, les tensions mesurées entre la deuxième borne de chaque transducteur et la borne commune étant d'égale amplitude et en opposition de phase dans la bande de transmission du filtre.

2. Filtre selon la revendication 1, caractérisé en ce que le transducteur d'émission est composé d'au moins deux peignes interdigités ayant des dents d'inégales longueurs aux bornes desquels est appliqué un signal électrique, ce transducteur ne transmettant que les signaux électriques dont la fréquence est comprise entre deux fréquences prédéterminées.

3. Filtre selon l'une des revendications 1 à 3, caractérisé en ce que les deux transducteurs récepteurs comprennent deux peignes à simple rangée de dents dont l'une des extrémités forme respectivement la deuxième borne de chaque transducteur et un peigne à double rangée de dents dont l'une des extrémités forme la première borne commune, les dents de chaque peigne à simple rangée de dents étant respectivement intercalées avec les dents d'une rangée du peigne à double rangée de dents.

4. Filtre selon la revendication 3, caractérisé en ce que les dents de tous les peignes faisant partie des moyens récepteurs sont d'égale longueur.

5. Filtre selon les revendications 2 et 3, caractérisé en ce que l'espacement entre les dents des peignes est constant, la distance entre une dent d'un peigne et la dent la plus proche du peigne intercalé est égale à la moitié de la longueur d'onde des ondes élastiques de surface propagées.

6. Filtre selon l'une des revendications 1 à 5, caractérisé en ce que le coupleur est formé d'un réseau de filaments conducteurs déposé sur ladite face perpendiculairement à la direction de propagation des ondes de surface dans chaque moitié.

7. Etage de fréquence intermédiaire d'un récepteur de télévision permettant d'extraire la bande de fréquence du canal image à partir d'un signal vidéofréquence, comprenant un filtre à ondes de surface connecté à un circuit à entrées différentielles, caractérisé en ce que le filtre à ondes de surface est un filtre selon l'une des revendications 1 à 6.

Fig. 1

Fig. 5

Fig. 2

0006054

Fig. 4

Fig. 3

0006054

| Catégorie | Citation du document avec indication, en cas de besoin, des parties pertinentes | Revendica-tion concernée | CLASSEMENT DE LA DEMANDE (Int. Cl.³) |
|---|---|---|---|
| | **GB - A - 1 433 398** (MULLARD)<br>* Figure 2; page 1, lignes 57-64; page 2, lignes 83-123 *<br>--- | 1,2,4,<br>6,7 | H 03 H 9/26<br>H 04 N 9/32 |
| | **US - A - 3 626 309** (T.J.KNOWLES)<br>* Figure 1; colonne 2, lignes 21-59; colonne 4, lignes 3-8 et 37-40 *<br>--- | 1,4,5 | |
| | **FR - A - 2 138 105** (PHILIPS)<br>* Figure 2; de la page 4, ligne 20 - la page 5, ligne 5 *<br>--- | 3 | **DOMAINES TECHNIQUES RECHERCHES (Int. Cl.³)**<br><br>H 03 H 9/26<br>H 03 H 9/30 |
| A | ELECTRONICS LETTERS, vol. 8, no. 19, 21 septembre 1972;<br>London (GB)<br>LA ROSA et al.: "Broadband Bulk Wave Cancellation in acoustic Surface Wave Devices",pages 478-479.<br>* Figure 1c; pages 478-479, le paragrpahe: "Cancellation Scheme" *<br>---- | 1 | |

**DOCUMENTS CONSIDERES COMME PERTINENTS**

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 07-09-1979 | COPPIETERS |

OEB Form 1503.1 06.78